# EUROPÄISCHE PATENTSCHRIFT

(11) **EP 3 990 936 B1**
(45) Veröffentlichungstag und Bekanntmachung des Hinweises auf die Patenterteilung: **09.11.2022**
(21) Anmeldenummer: 20754207.7
(22) Anmeldetag: 06.08.2020
(51) Int. Cl.: G01R 33/38, G01R 33/383, G01R 33/46

(54) **TEMPERIERSYSTEM FÜR MAGNETRESONANZ-GERÄTE MIT PERMANENTMAGNETANORDNUNG**
TEMPERATURE CONTROL SYSTEM FOR MAGNETIC RESONANCE DEVICES HAVING A PERMANENT MAGNET ARRANGEMENT
SYSTÈME DE THERMORÉGULATION POUR APPAREILS À RÉSONANCE MAGNÉTIQUE ÉQUIPÉS D'UN ENSEMBLE AIMANT PERMANENT

(30) Priorität: 21.08.2019 DE 102019212508
(43) Veröffentlichungstag der Anmeldung: 04.05.2022
(73) Patentinhaber: Bruker Switzerland AG, 8117 Fällanden (CH)
(72) Erfinder: FREYTAG, Nicolas, 8122 Binz (CH); HELBING, Florian, 8037 Zürich (CH); MEISTER, Roger, 8132 Hinteregg (CH); ZAFFALON, Michele, 8038 Zürich (CH)
(74) Vertreter: Kohler Schmid Möbus Patentanwälte
(86) Internationale Anmeldenummer: PCT/EP2020/072084
(87) Internationale Veröffentlichungsnummer: WO 2021/032491

(56) Entgegenhaltungen:
- EP-A1- 2 507 643
- DE-A1-102010 002 316
- DE-T2- 69 915 316
- JP-A- H05 212 012
- JP-A- H05 285 118

## Beschreibung

Die Erfindung betrifft das Temperieren eines NMR-Magnetsystems umfassend eine Permanentmagnetanordnung mit einem zentralen Luftspalt zur Erzeugung eines homogenen statischen Magnetfeldes in einem Messvolumen innerhalb des zentralen Luftspalts, einen NMR-Probenkopf zum Senden von HF-Pulsen und Empfangen von HF-Signalen aus einer Messprobe, einen NMR-Frequenzlock umfassend eine Frequenzdetektion im NMR-Probenkopf und eine H0-Spule zur Veränderung der Amplitude des statischen Magnetfeldes, und ein Shimsystem im zentralen Luftspalt zur weiteren Homogenisierung des Magnetfeldes im Messvolumen, wobei eine erste Isolierkammer die Permanentmagnetanordnung thermisch abschirmend umschließt, und wobei die erste Isolierkammer ein oder mehrere Mittel zur Regelung einer Temperatur T1 der ersten Isolierkammer umfasst.

Ein solches temperierbares NMR-Magnetsystem ist aus der DE 10 2010 002316 A1 (= Referenz [0]) bekannt geworden.

Die US 2011/0137589 A1 beziehungsweise die EP 2 507 643 A1 (= Referenz [1]) beschreiben ein ähnliches Magnetresonanzsystem.

### Hintergrund der Erfindung

Die vorliegende Erfindung befasst sich allgemein mit der Temperierung von Permanentmagnetsystemen, insbesondere für Benchtop-NMR-Geräte.

Bei Permanentmagneten ist das erzeugte Magnetfeld abhängig von den ferromagnetischen Eigenschaften des verwendeten Permanentmagnet-Materials. Diese Eigenschaften wiederum sind stark temperaturabhängig. Bei Eisen-Bor-Neodym Magneten etwa weist die Koerzitivfeldstärke einen Temperaturkoeffizienten von ca. -0,6 %/K und die Remanenz einen Temperaturkoeffizienten von ca. 0,1 %/K auf. Deshalb ist es, insbesondere bei der Verwendung von Permanentmagnetanordnungen für hochauflösende NMR mit sub-Hertz Linienbreiten, wichtig, die Permanentmagnetanordnung thermisch sehr präzise zu regulieren. Es gilt dabei, die Temperatur (T) über eine ausreichend lange Zeit stabil zu halten, vorzugsweise Temperaturschwankungen auf 1/1000 K zu minimieren, um eine Drift oder Schwankung des B0-Feldes zu vermeiden, die zu Resonanzlinienverbreiterungen bei der Akkumulation von Spektren zur Erhöhung des Signal-zu-Rausch-Verhältnis (S/N) oder Distorsionen von Linienformen bei Veränderungen der Magnetfeldstärke über die Zeitdauer einer Akquisition hinweg führen können. Gleichzeitig sollen Messbedingungen gewährleistet sein bei einer möglichst niedrigen Magnettemperatur, vorzugsweise im Bereich der Raumtemperatur (298 K ist Standard), um NMR Messungen ohne Sample-Temperierung zu ermöglichen. Wird die Magnettemperatur weiter abgesenkt, kann das resultierende B0-Feld maximiert und thermisch angeregte Relaxation des Magneten verlangsamt werden. Idealerweise soll das B0 Feld mindestens 1,5 T, vorzugsweise 1,9 T oder höher, betragen.

Manche derzeit kommerziell verfügbaren Geräte haben keine variable Messproben-Temperatur, sondern die Messproben werden bei der Betriebstemperatur des Magneten gemessen. Werden sehr warme/kalte Messproben eingeführt, führt dies zu schädlichen B0 Homogenitätsänderungen durch entstehende Temperaturgradienten im Magnetsystem. Weiterhin verlängert sich die Messzeit um die Zeit, die es benötigt um ein thermisches Equilibrium in den Messproben zu erreichen, was ohne aktive Temperierung deutlich länger dauert, als z.B. unter Zuhilfenahme von Temperiergasströmen.

Gemäß einigen Veröffentlichungen wird statt einer Messprobe eine vakuumisolierte Flow-Zelle in das Benchtop-Gerät eingeführt und die Messprobentemperatur wird außerhalb des Magneten eingestellt und geregelt. Dies führt zu deutlichen Verlusten im S/N durch ein reduziertes Messprobenvolumen. Alternativ werden Flusszellen verwendet, die nicht thermisch isoliert sind. Dabei wird dann akzeptiert, dass die Messprobentemperatur im Messbereich und Auslass sich eventuell deutlich von der Temperatur im Zufluss unterscheidet. Dies kann wesentliche Probleme bereiten, z.B., wenn Lösungen ausfallen, etwa, wenn sie im Bereich der Magnettemperatur übersättigt sind.

### Spezieller Stand der Technik

### Magnettemperierung:

In US 8,461,841 B2 (= Referenz [2]) wird eine NMR Vorrichtung mit einem Permanentmagneten beschrieben, welcher über Bohrungen mittels eines Temperierfluids auf die gewünschte Temperatur gebracht wird. Eine Kontrolle der Magnettemperatur wird mittels T-Sensoren durchgeführt und entsprechend der Fluss und die Temperatur des Fluids angepasst. Eine präzise Temperaturregelung im mK-Bereich kann mit dieser Vorrichtung jedoch nicht erreicht werden.

US 6,489,873 B1 (= Referenz [3]) offenbart ein Temperaturregelsystem für ein Joch-basiertes offenes Permanentmagnetsystem, bei dem die Permanentmagnetanordnung über eine Vielzahl von thermoelektrischen Wärmepumpenvorrichtungen in thermischem Kontakt mit einem C-Joch montiert ist. Mindestens ein Temperatursensor ist mit einer elektronischen Steuerschaltung verbunden. Auch bei dieser Vorrichtung ist keine genaue T-Kontrolle im mK-Bereich möglich, da es über keine geschlossene Kammer verfügt.

US 6,566,880 B1 und WO 2000/016117 A1 (= Referenz [4]) beschreiben einen Magnetresonanz-Tomographen, der mit Permanentmagnet-Baugruppen ausgestattet ist, welche an einem Joch angebracht sind. Der Tomograph umfasst weiterhin Gradientenspulen. Jede Permanentmagnet-Baugruppe befindet sich in Wärmekontakt mit einer Platte, die eine gute Wärmeleitfähigkeit aufweist und zwischen den Permanentmagnet-Baugruppen und den Gradientenspulen angeordnet ist. Es gibt weiterhin eine Temperaturregelung mit Temperaturfühlern, die mit der Platte verbunden sind und thermoelektrische Wärmepumpvorrichtungen ansteuern. Auch hier ist wiederum ein offenes System vorhanden, wobei die Temperiervorrichtung den Wärmeeintrag durch die Gradientenschaltungen begrenzen soll.

In GB 2512328 A (= Referenz [5]) wird ein NMR System mit Permanentmagneten beschrieben, das mit Temperatursensoren ausgestattet ist und die Magneten direkt mittels Heizplatten mit Wärme beschickt sind. Sensoren sind an verschiedenen Stellen des Magneten angebracht und geben die Information an einen Controller, der wiederum die Heizplatten ansteuert.

JP H05 212012 A (= Referenz [13]) und JP H05 285118 A (= Referenz [14]) offenbaren ein Magnetresonanzbildgebungssystem -allerdings ohne NMR-Probenkopf, Shimsystem oder H0-Spule- mit einem Wärmeleitkörper zwischen einer Gradientenspule und einer Permanentmagnetanordnung, wobei die Gradientenspule nicht außerhalb der Isolierkammer angebracht ist.

US 8,030,927 B2 (= Referenz [6]) beschreibt eine Tomographievorrichtung mit Permanentmagnet, wobei ein Magnet-Temperatursteuergerät zum Halten der Temperaturstabilität im Inneren des Magneten vorhanden ist. Die Magnet-Temperatursteuerungsvorrichtung weist eine Rohrleitung und einen Temperaturregler auf, wobei die Rohrleitung eine darin zirkulierende Flüssigkeit oder ein darin zirkulierendes Gas aufweist und der Temperaturregler in Reihe mit der Rohrleitung verbunden ist, um die Temperatur der Flüssigkeit oder des Gases zu regeln. Im Vergleich zu den Referenzen [3] bis [5] ist hier aufgrund der Fluidzirkulation eine genauere T-Regelung möglich. Jedoch wird der Eintrag der Gradienten- oder Shimspulen nicht berücksichtigt.

### Thermische Isolierung:

US 7,297,907 B2 (= Referenz [7]) beschreibt ein Verfahren zur aktiven thermischen Isolierung eines NMR-Permanentmagneten, der sich in einer Hülle befindet ("thermally insulated virtual envelope") gegenüber der Probe, die sich innerhalb der Magnetbohrung befindet. Es wird ein sogenanntes "aktives Shielding" eingesetzt wird, bei welchem eine Temperierflüssigkeit zwischen den beiden thermisch zu trennenden Bauteilen durchgeleitet wird. Weiterhin wird offenbart, dass die Magnetbaugruppe auch passive Isolierschichten umfassen kann. Allerdings werden Shimspulen beschrieben, die aktive Shimelemente umfassen können, welche direkt um die Magneten positioniert sein können. Somit ist es nicht Ziel dieser Anordnung, den Wärmeeintrag durch Ströme in der H0-Spule und/oder den Shimspulen in das Magnetmaterial zu begrenzen. Es werden zwar keine Temperaturwerte explizit genannt, jedoch ist bei diesem Aufbau davon auszugehen, dass große Temperaturunterschiede zwischen der Messprobe und den Magneten thermisch getrennt werden sollen. Eine präzise T-Regelung des Magneten liegt allerdings nicht im Fokus.

Eine weitere Magnetkonfiguration ist bekannt aus US 2013/0207657 A1 (= Referenz [8]). Aus diesem Dokument geht jedoch nicht hervor, dass zwischen Messprobe und Polschuh respektive zwischen Polschuh und Magnetmaterial eine temperierbare Barriere oder Isolation vorgesehen ist.

### Shimmen mit T-Kontrolle:

Ein elektronisches Shimmen des Magnetfelds erfolgt mittels einer Vielzahl Shimspulen, die bei Bestromung unterschiedliche Feldgradienten im Messvolumen erzeugen.

US 9,285,441 B1 (= Referenz [9]) beschreibt ein Magnetfeld-Korrektursystem für NMR Anwendungen. Insbesondere geht es um das elektronische Shimmen, um ein homogenes Magnetfeld im Field-of-View zu erzielen. Dieses Dokument adressiert zwar die Problematik der Temperaturänderungen in Magnet- und Shim-Systemen, insbesondere eine Drift des Magnetfelds, allerdings wird dies gemäß Referenz [9] nicht behoben durch ein Temperiersystem, sondern durch bloßes Anpassen der Ströme durch die Shimspulen.

US 2011/0037467 A1 (= Referenz [10]) beschreibt ähnliche Problemlösungen in der MR Bildgebung. Wenn die Temperatur in einem Shim-Material variiert, ändert sich die Homogenität des statischen Magnetfelds. Daher wird ein Temperatursensor an den Shims vorgeschlagen, der Informationen an einen Controller schickt, wobei der Kontroller daraus die Inhomogenität bestimmt. Ein Temperiersystem für die Shims ist auch hier nicht vorgesehen.

### T-Kontrolle mit Wärmepumpen und Wärmetauschern:

US 2018/0038924 A1 (= Referenz [11]) offenbart ein NMR System für Hochtemperaturmessungen. Der Probenkopf ist hierfür mit einer thermischen Isolierung zum Magnet hin ausgestattet. Diese Isolierung oder thermische Barriere umfasst eine Wärmesenke, z.B. bestehend aus Heatpipes oder Wärmepumpen (Peltier Elementen) sowie eine thermische Isolierung in Form einer Wand. Des Weiteren sind die Polschuhe des Permanentmagneten temperierbar, um Temperaturgradienten im Magneten zu verhindern. Auch eine Art Gasfluss zur Temperierung der Messprobe (VT-Gasfluss) wird gezeigt.

US 2016/0077176 A1 (= Referenz [12]) beschreibt eine NMR Probenkopfkassette, die einen ersten entfernbaren Verbindungskörper umfasst, der aus einem nicht magnetischen Material hergestellt ist. Der Verbindungskörper ist reversibel mit einem Wärmetauscher verbunden, um den Verbindungskörper im Wesentlichen auf einer vorbestimmten Temperatur zu halten. Eine Magnettemperierung ist allerdings nicht thematisiert.

In der eingangs zitierten Referenz [1] wird eine gattungsgemäße Anordnung mit den eingangs genannten Merkmalen sowie ein Verfahren zur Erzeugung eines homogenen Magnetfelds beschrieben. Aus Referenz [1]) geht hervor, dass lediglich der Magnet direkt temperiert wird. Zwischenlagen, insbesondere zwischen Magnet und/oder Polschuh und Shimsystem, für eine indirekte Temperierung sind nicht angedeutet. Die in Referenz [1] beschriebene Vorrichtung zur Magnettemperierung ist (gemäß Blockschaltbild) lediglich mit dem Magneten selbst verbunden, nicht jedoch mit dem Shimsystem oder den Polschuhen. Auch eine thermische Kapselung des Magnetsystems ist nicht vorgesehen. Auf die Problematik einer thermischen und mechanischen Ankopplung wird in dem Dokument nicht näher eingegangen.

### Aufgabe der Erfindung

Der vorliegenden Erfindung liegt demgegenüber die Aufgabe zugrunde, ein Temperiersystem für ein NMR-Magnetsystem der eingangs beschriebenen Art mit möglichst unaufwändigen technischen Mitteln dahingehend zu verbessern, dass die oben diskutierten Nachteile bekannter gattungsgemäßer Anordnungen vermieden werden. Insbesondere soll die mit der vorliegenden Erfindung verbesserte NMR-Vorrichtung die Möglichkeit bieten,
1. eine variable Messprobentemperatur einzustellen,
2. in kurzer Zeit große Änderungen von Shimströmen zu erzeugen, ohne dass das Magnetsystem lange Zeit driftet,
3. schnelle Änderungen von Strömen in einer H0-Spule bewirken zu können sowie eine große maximale Amplitude des Lockbereiches zu erlauben, ohne dass das Magnetsystem mit einer langsamen Drift und veränderten Feldgradienten darauf reagiert,
4. erhöhte Feldstabilität im Vergleich zu den Geräten nach dem Stand der Technik zu erreichen, insbesondere beim Wechsel von Messproben,
5. die Temperatur des Permanentmagneten so zu regeln, dass eine konstante Temperatur oder ggf. stabile Temperaturgradienten im Magneten ermöglicht wird, insbesondere unabhängig von Wärmeeinträgen aufgrund von Shimströmen oder im Bereich der Messkammer, also an der Innenseite des Permanentmagneten, welcher entscheidend für die Feldstabilität in der Messkammer ist, aber auch durch äußere Einflüsse, wie beispielsweise die Raumtemperatur oder Sonneneinstrahlung auf das Gerät.

### Kurze Beschreibung der Erfindung

Diese -im Detail betrachtet relativ anspruchsvolle und komplexe- Aufgabe wird durch die vorliegende Erfindung auf ebenso überraschend einfache wie wirkungsvolle Weise dadurch gelöst, dass bei einem Temperiersystem für ein NMR-Magnetsystem der eingangs definierten Art das Shimsystem, die H0-Spule sowie der NMR-Probenkopf außerhalb der ersten Isolierkammer im zentralen Luftspalt angeordnet sind, und dass mindestens ein Wärmeleitkörper zwischen dem Shimsystem und der H0-Spule einerseits und der Permanentmagnetanordnung andererseits angeordnet ist.

Bei der vorliegenden Erfindung geht es vor allem darum, eine möglichst «feinfühlige» Temperaturregelung des Permanentmagnetsystems auf wenige mK genau zu erreichen.

Dieses Ziel wird erfindungsgemäß insbesondere erreicht durch ein NMR-Magnetsystem, bei welchem der Permanentmagnet in einem innen und außen geschlossenen System angeordnet ist. Der Magnet ist vollständig umgeben von einer isothermen Wandung und bleibt daher durch aktive Abschirmung unbeeinflusst von einem Wärmeeintrag von verschiedenen Seiten. Der Permanentmagnet hat eine Innenkontur, in welcher das Shimsystem, die H0-Spule und der NMR-Messkopf angeordnet sind, mit zumindest abschnittsweise rechteckigem, polyedrischem, elliptischem oder rundem Querschnitt.

Die Mittel zur Temperierung der Temperatur T1 sind auf der Wandung der ersten Isolierkammer angeordnet, damit sich die Wärme zum Magneten hin auf der Basis von Strahlung, Wärmeleitung im Gas und eventuell Konvektion in der Kammer mit einer Trägheit nach Art eines Tiefpasssystems überträgt. Vorzugsweise sind die Mittel durch Heizfolien, die großflächig auf der Oberfläche der äußeren Wandung montiert werden realisiert. Alternativ ist die Wandung als guter thermischer Leiter ausgeführt und wird lediglich lokal mit Wärme beschickt, die sich durch die Wand ausbreitet.

Das Material der Innenwandung, d.h. die Fläche der ersten Isolierkammer, die an die Innenkontur der Magnetanordnung angrenzt, ist vorzugsweise aus einem thermisch gut leitenden Material ausgeführt, und/oder grenzt an den Wärmeleitkörper an. Idealerweise umfasst zumindest ein Teil diese Fläche den Wärmeleitkörper. Das ist vorteilhaft für die homogene Wärmeverteilung im Innenraum der ersten Isolierkammer und erlaubt es eine thermische Regelung durch Quellen/Senken außerhalb des Luftspaltes zu realisieren. Insbesondere ist dies vorteilhaft, wenn Wärmeeinträge lokal erfolgen, wie z.B. durch Dissipation in Shimspulen oder der H0-Spule.

Der Wärmeleitkörper hat die Funktion einer thermischen Abschirmung des Magneten und der aktiven Temperierung der Innenwandung und der Innenkontur der Magnetanordnung mit der Temperatur T2 des Wärmeleitkörpers.

Die Regelung der Magnettemperatur erfolgt indirekt, da der Magnet nur wenige Kontaktpunkte mit geringer thermischer Leitfähigkeit zur Wandung haben soll (i.e. die Befestigungspunkte des Magneten gegenüber dem Gehäuse). Die Magnettemperatur beträgt vorzugsweise zwischen 15°C und 35°C.

Die durchschnittliche Temperatur des Magneten selbst ist auf eine Temperatur TM eingestellt, für die gilt T1 < TM < T2 oder T1 > TM > T2, falls T1 ≠ T2 und TM = T1 = T2, falls T1 = T2. TM ist bevorzugt auf 0,1 K, insbesondere auf 0,01 K, besonders bevorzugt auf 0,001 K genau einstellbar. Die Temperatur TR des Raums, welcher das MR-Spektrometer umgibt, liegt im Betrieb zwischen einer minimalen Temperatur TRmin und einer maximalen Temperatur TRmax, also TRmin ≤ TR ≤ TRmax und für die Magnettemperatur TM gilt: TRmin < TM < TRmax.

Im Vergleich zum Stand der Technik, bei welchem der Magnet aktiv auf Temperaturen über der Raumtemperatur TR, z.B. 40°C, geheizt wird, kann man mit der Erfindung Messproben ohne zusätzliche Probentemperierung bei Raumtemperatur vermessen. Dadurch ist die Equilibrierungszeit nach dem Einführen einer Messprobe deutlich kürzer und eine NMR-Messung kann wesentlich schneller durchgeführt werden.

Ein weiterer Vorteil besteht darin, dass das NMR-Spektrometer nach Installation (also nach dem Einschalten) schneller temperiert ist und nicht mehr driftet, da die Wärmeleitung des Magnetmaterials gering ist. Es erweist sich als ein großer Vorzug, dass damit die Zieltemperatur des Magneten möglichst nah an der Lagertemperatur des ausgeschalteten Messgerätes gehalten werden kann.

Ein wesentlicher Unterschied der Erfindung zu bekannten Geräten liegt in der Regelung der Temperatur T2 des Wärmeleitkörpers, die von der Innenkontur des Magneten "gesehen" wird. Weiterhin ist es neu, eine thermische Isolation zwischen der Probentemperierkammer und dem Shimsystem vorzusehen. Aus den oben zitierten Dokumenten geht hervor, dass bei den Geräten nach dem Stand der Technik die Isolation zwischen der Messprobe und der inneren Wand der Probentemperierkammer, insbesondere jedoch innerhalb der Sende/Empfangsspule platziert wird.

### Bevorzugte Ausführungsformen und Weiterbildungen der Erfindung

Ganz besonders bevorzugt ist eine Ausführungsform des erfindungsgemäßen Temperiersystems, bei der ein oder mehrere Mittel zur Regelung einer Temperatur T2 des Wärmeleitkörpers außerhalb der ersten Isolierkammer angeordnet sind. Der zentrale Luftspalt entspricht der Bohrung des Magneten, in dessen Zentrum sich der Probenkopf mit der Messkammer und der RF Spule befindet. Radial außerhalb ist das Shimsystem mit integrierter H0-Spule angeordnet, das der Permanentmagnetanordnung benachbart angeordnet ist. Die Wärme-entwicklung durch die Ströme des Shimsystems und der H0-Spule wird durch das Wärmeleitsystem abtransportiert und über den Wärmetauscher an die Umgebung abgegeben. Die Temperiervorrichtung regelt die Temperatur des Wärmeleitkörpers auf die Temperatur T2. Dadurch ist gewährleistet, dass der Wärmeeintrag in Richtung des Permanentmagneten konstant gehalten ist, falls T2 > T1 bzw. die Wärmeaufnahme aus dem Permanentmagneten konstant gehalten ist, falls T1 > T2. Vorzugsweise gilt T2 = T1, sodass keine Temperaturvarianzen innerhalb der Kammer und insbesondere innerhalb des Magneten entstehen. In diesem Fall gilt TM = T1 = T2 und es findet kein Wärmeübertrag aus dem Magnetsystem in die erste Isolierkammer statt. Dies ist besonders vorteilhaft, da das initiale (z.B. mechanische oder ferromagnetische) Shimmen des Magneten unabhängig von der Temperierung und eventueller Temperaturgradienten innerhalb des Magneten erfolgen kann.

Vorteilhafte Weiterbildungen dieser Ausführungsform sehen vor, dass die die Permanentmagnetanordnung umhüllende erste Isolierkammer eine Wandung aus mindestens zwei thermisch unterscheidbare Flächen aufweist, die jeweils mindestens einen Sensor zur Bestimmung einer Oberflächentemperatur T1i der Fläche umfassen und eine voneinander unabhängige thermische Regelung aufweisen.

Vorteilhaft sind auch Ausführungsformen der Erfindung, bei denen mindestens eines der Mittel zur Regelung der Temperatur T1 der ersten Isolierkammer oder der Temperatur T2 des Wärmeleitkörpers ein thermo-elektrisches Element ist und einen Wärmetauscher aufweist. Thermoelektrische Elemente, wie etwa ein Peltier Element, ermöglichen eine besonders präzise Einstellung der Temperatur T1/T2. Insbesondere erlauben sie gleichermaßen zu kühlen und zu heizen, was eine effiziente und sehr schnelle Regelung erlaubt und die Möglichkeit bietet, auch größere Wärmeströme aus dem System zu ziehen.

Weitere vorteilhafte Ausführungsformen der Erfindung zeichnen sich dadurch aus, dass die Wandung der ersten Isolierkammer zugleich als Abschirmanordnung zur magnetischen Abschirmung des Magnetfeldes gegenüber einem Außenraum gestaltet ist, d.h. aus einem oder mehreren ferromagnetischen Materialien gefertigt ist, und vorzugsweise eine passive thermische Isolation auf der Außenseite der ersten Isolierkammer umfasst. Die Wandung kann hierbei außerdem auch gleichzeitig eine HF-Abschirmung darstellen.

Vorteilhaft sind auch Ausführungsformen des erfindungsgemäßen Temperiersystems, die dadurch gekennzeichnet sind, dass der Wärmeleitkörper aus einem Homogenisierungskörper und einer Wärmeleitungseinrichtung besteht. Der Homogenisierungskörper besteht zum Beispiel aus einem gut thermisch leitfähigen Material (Cu) und dient dazu, die Wärme möglichst homogen über seine gesamte Fläche zu verteilen, sodass die Temperaturgradienten minimal sind.

Bei bevorzugten Weiterbildungen dieser Ausführungsformen umfasst die Wärmeleitungseinrichtung mindestens eine Heatpipe. Heatpipes oder Wärmerohre transportieren die Wärme effizienter als reine Wärmeleiter.

Bei einer weiteren bevorzugten Weiterbildung besteht der Homogenisierungskörper aus einem Wärmespreizer/3D-Heatdiffusor, d.h. einem nichtzylindrischen Wärmerohr, das Wärme effizienter als reine Wärmeleiter transportiert und somit mit geringerer Bauhöhe eine vergleichbare Homogenisierung erreichen kann.

Alternativ oder ergänzend kann bei anderen Weiterbildungen der Homogenisierungskörper thermisch mit dem Shimsystem und der H0-Spule verbunden sein. Dies ermöglicht es, die Dissipation der Shim/H0-Ströme aus dem Luftspalt des Magneten zu entfernen und trägt dazu bei, eine möglichst konstante Temperatur des Messraumes zu erreichen, wenn keine Vorrichtung zur Einstellung der Messprobentemperatur vorhanden ist.

Bevorzugt sind auch Weiterbildungen, bei welchen mindestens ein Teil des Homogenisierungskörpers zwischen dem Shimsystem und der Permanentmagnetanordnung angeordnet ist.

Der Homogenisierungskörper ist vor allem deshalb zwischen dem Shimsystem und dem Permanentmagnetsystem angeordnet, damit man eine gleichmäßige Verteilung der Temperatur T2 am angrenzenden Magneten erhält.

Andere Weiterbildungen zeichnen sich dadurch aus, dass das das Mittel zur Regelung der Temperatur T2 im zentralen Luftspalt einen Heizer und/oder einen Temperatursensor zur Messung der Temperatur T2 und/oder ein thermoelektrisches Element umfasst und thermisch mit dem Shimsystem und/oder dem Wärmeleitsystem verbunden ist.

Eine Klasse von Ausführungsformen der Erfindung ist dadurch gekennzeichnet, dass die erste Isolierkammer von einer zweiten Isolierkammer umgeben ist, welche auf einer Temperatur T3 liegt und mit welcher die Temperatur T3 im Inneren der zweiten Isolierkammer gegenüber der Umgebungstemperatur TR außerhalb der zweiten Isolierkammer isoliert wird.

Aus dieser Kaskadierung von Isolierkammern ergibt sich, dass die Temperaturstabilität der Regelung der Temperatur T1 an der Wandung des ersten Kammer und/oder der Temperatur T2 des Wärmeleitsystems um mindestens eine Größenordnung höher ist als die Stabilität der Temperatur im Zwischenraum T3.

Hierbei wird insbesondere T3 auf besser als ±1 K, vorzugsweise auf besser als ±0,1 K sowie T1 und T2 auf besser als ±0,1 K, vorzugsweise auf besser als ±0,01 K, idealerweise auf ±0,001 K stabilisiert.

Dabei gilt: TRmin ≤ T3 ≤ TRmax.

Bevorzugt gilt weiterhin T1 > T3, da in diesem Falle die Regelung der Temperatur T1 durch Heizen gegenüber der Wärmesenke auf T3 erfolgen kann und keine thermoelektrischen Elemente zum Erreichen der konstanten Temperatur T1 der Wandung der ersten Isolierkammer notwendig sind.

Bei bevorzugten Weiterbildungen dieser Klasse von Ausführungsformen ist eine Temperaturregeleinrichtung der zweiten Isolierkammer vorhanden, welche die Temperatur T3 im inneren der zweiten Isolierkammer gegen die Umgebungstemperatur TR außerhalb der zweiten Isolierkammer regelt. Vorzugsweise ist die Temperatur T1 der Innenwand des ersten Temperiersystems und/oder die Temperatur T2 des Wärmeleitsystems kleiner oder größer als die Temperatur T3 im Zwischenraum ist, und wobei insbesondere die Temperaturdifferenz mindestens 2 K beträgt. Somit können die Temperaturen T1 und T2 gegen einen möglichst konstanten Hintergrund sehr präzise geregelt werden und ein konstanter Wärmefluss von der ersten Isolierkammer und dem Wärmeleitsystem wird gegenüber der zweiten Isolierkammer sichergestellt.

Besonders bevorzugt ist eine Ausführungsform, bei der T3 < T1 gilt. In diesem Falle kann die Temperaturregelung von T1 lediglich mit Heizelementen erreicht werden, und muss nicht mit thermoelektrischen Elementen erfolgen, da nie gekühlt werden muss.

Wird ein thermoelektrisches Element zur Regelung der Temperatur T2 verwendet, kann der Wärmetauscher die Wärme entweder gegen die Temperatur T3 oder aber auch gegen die Umgebungsluft bei Raumtemperatur austauschen. Eine Konfiguration mit Regelung gegen T3 erhöht die Regelgenauigkeit aufgrund der Kaskadierung, eine Konfiguration mit Regelung gegen Raumtemperatur erschwert es, eine besonders stabile Regelung der Temperatur T2 unabhängig von der Raumtemperatur und eventueller Wärmeeinstrahlung z.B. durch Sonnenlicht zu erreichen, erlaubt es jedoch, große Wärmeströme, effizient zu dissipieren, ohne dadurch eine Erwärmung einer oder mehrerer Wände der ersten Isolierkammer und insbesondere große Temperaturgradienten innerhalb der zweiten Isolierkammer zu riskieren.

Ganz besonders vorteilhaft ist eine Klasse von Ausführungsformen der Erfindung, bei welchen der Probenkopf ein oder mehrere Mittel zur Einstellung der Temperatur TS einer Messprobe im Messvolumen aufweist, die unabhängig von der Temperatur T1/T2 der die Permanentmagnetanordnung umhüllenden Wandung einstellbar ist. Dieser Gasfluss dient der Temperierung der Messprobe, was zur Folge hat, dass neben den Shimspulen noch ein weiterer Temperatureintrag im Luftspalt des NMR-Magnetsystems vorhanden ist, welcher durch das Wärmeleitsystem abtransportiert werden muss.

Vorzugsweise erfolgt die Einstellung der Temperatur TS der Messprobe im Bereich -40 bis +150°C mittels eines temperierten Probentemperierungs-Gasstroms (VT-Gasstrom). Beim Wechsel der Messprobentemperatur treten sehr große Veränderungen des Wärmeeintrags in das Magnetresonanzsystem auf, die wegen der großen Trägheit der Magnete aufgrund schlechter Wärmeleitung des Magnetmaterials zu sehr langsamen Veränderungen der Magnetfeldstärke, insbesondere jedoch der Magnetfeldhomogenität führen können. Eine ähnliche Situation kann auch während des Einstellens der elektrischen Shims auftreten, nicht jedoch im stationären (geshimmten) Zustand. Daher ist es für einen effizienten Betrieb besonders wichtig diese Wärmequelle/senke möglichst effizient vom Magneten zu entkoppeln, was in der bevorzugten Ausführungsform durch die aktive Regelung der Temperatur T2 und die Kombination aus Wärmeleitsystem und Homogenisierungskörper erreicht wird.

Günstig sind Weiterbildungen dieser Klasse von Ausführungsformen, bei denen ein Isolationssystem zwischen dem Shimsystem und mindestens einer HF-Spule des NMR-Probenkopfes angeordnet ist, wobei vorzugsweise ein auf eine Temperatur TF temperierter Spülgasstrom (Flushgas), durch den NMR-Probenkopf, das Shimsystem oder die H0-Spule fließt.

Vorzugsweise wird der Probentemperierungsgasstrom (VT-Gasstrom) und zumindest ein Teil des Spülgasstroms vor dem Austritt aus dem Spektrometer gemischt.

Alternativ kann dieses Isoliersystem als Dewar ausgeführt, d.h. evakuiert sein.

Weiter kann ein mit dem erfindungsgemäßen Temperiersystem ausgerüstetes Magnetresonanzspektrometer dadurch gekennzeichnet sein, dass die absolute zeitliche Stabilität der Temperatur T3 zumindest am Ort eines Temperatursensors im Bereich T3 = <T3> ± 1K, vorzugsweise ± 0,1K liegt.

Die absolute zeitliche Stabilität der mindestens einen Temperatur T1i zumindest am Ort des jeweiligen Temperatursensors liegt im Bereich T1i = <T1i> ± 0,1 K, besser ± 0,01 K, idealerweise ± 0,001 K.

Die absolute zeitliche Stabilität der Temperatur T2 zumindest am Ort mindestens eines Temperatursensors liegt im Bereich T1 = <T2> ± 0,1 K, besser ± 0,01 K, idealerweise ± 0,001 K.

Die relative Differenz zwischen zwei Temperaturen auf der die Magnetanordnung umhüllenden Fläche T1i und T1j ist kleiner ist als 1 K, besser kleiner als 0,1 K und im Idealfall kleiner als 0,01 K.

Der NMR-Probenkopf umfasst, wie üblich, eine Messprobenkammer, die im Betrieb eine Messprobe aufnimmt und optional aus einem Material mit geringer thermischer Leitfähigkeit bestehen kann (beispielsweise aus Glas, Quarz, Teflon, ...). Der Probenkopf enthält eine erste Sende-/Empfangsspule, welche die Messprobenkammer umgibt oder von dieser umgeben wird. Vorzugsweise umfasst der Messkopf auch ein Netzwerk zum Abstimmen verschiedener Resonanzfrequenzen auf der ersten Sende-/Empfangsspule.

Weiterhin umfasst der Probenkopf optional eine zweite Sende-/Empfangsspule, auf der weitere Messkerne abgestimmt sein können, z.B. die Lockfrequenz.

In einer anderen Ausführungsform enthält der Messkopf eine weitere Messprobe mit einer Substanz, die durch eine zweite oder dritte Sende-/Empfangsspule detektiert wird und als Referenzsignal für den Lock verwendet wird.

Das Permanentmagnetmaterial ist typischerweise etwa Eisen-Bor-Neodym, Kobalt-Samarium, etc. und umfasst optional zusätzlich auch ferromagnetisches Material, beispielsweise Eisen, Kobalteisen und dergleichen.

Typischerweise sind Polschuhe am Magneten angeordnet, welche Messkopfseitig am Magneten angebracht sind.

Das Magnetsystem und die isotherme Wand umfassen "Mittel zur Regelung der Temperatur", wie z.B. Heizer, thermoelektrische Elemente mit einer Wärmesenke (Wärmetauscher) oder Ähnliches.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden, sofern das Resultat unter die Ansprüche fällt. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematische Vertikalschnittansicht einer ersten Ausführungsform des erfindungsgemäßen Temperiersystems mit erster Isolierkammer, Temperaturregler und Wärmeleitkörper;
- Fig. 2: eine erfindungsgemäß temperierte Permanentmagnetanordnung mit zusätzlicher T2-Regelung, thermischer Isolierung und einem geschlossenen Luftspalt;
- Fig. 3: eine Ausführungsform der Erfindung mit einer zweiten Isolierkammer, geschlossenem Luftspalt sowie zusätzlicher T3-Regelung;
- Fig. 4: eine Ausführungsform mit zwei Isolierkammern, offenem Luftspalt, T1-, T2- und T3-Regelung sowie mit Temperierung des Wärmeleitkörpers gegen die Umgebungstemperatur;
- Fig. 5: einen schematischen Vertikalschnitt durch eine erfindungsgemäße Ausführungsform des NMR-Probenkopfes mit thermischem Isolationssystem und temperiertem Spülgasstrom und temperiertem VT-Gasstrom zur Probentemperierung;
- Fig. 6: Querschnitte durch Probenköpfe mit Shimsystem, Wärmeleitkörpern sowie Homogenisierungskörpern; und
- Fig. 7: eine eine schematische Vertikalschnittansicht eines Temperiersystems nach dem Stand der Technik.

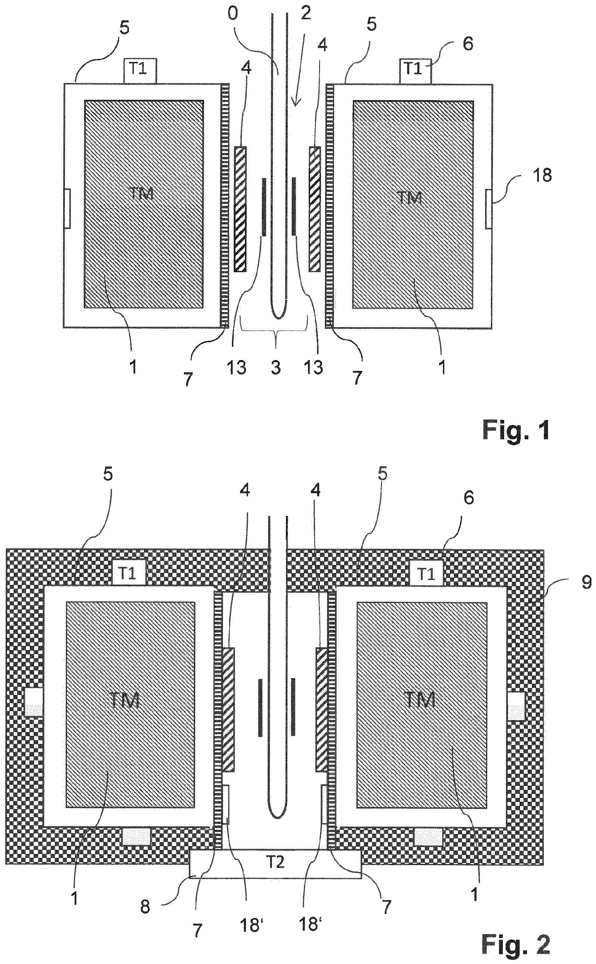

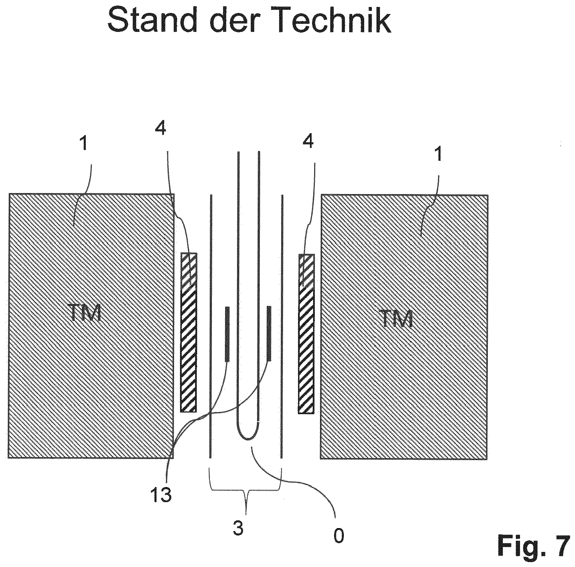

Die Figuren 1 bis 6 der Zeichnung zeigen jeweils in einer schematischen Ansicht in unterschiedlichem Detail bevorzugte Ausführungsformen des erfindungsgemäßen Temperiersystems, während **Fig. 7** eine generische Anordnung nach dem Stand der Technik darstellt.

Ein derartiges Temperiersystem für ein NMR-Magnetsystem umfasst eine **Permanentmagnetanordnung 1** mit einem **zentralen Luftspalt 2** zur Erzeugung eines homogenen statischen Magnetfeldes in einem Messvolumen innerhalb des zentralen Luftspalts 2, einen **NMR-Probenkopf 3** zum Senden von HF-Pulsen und Empfangen von HF-Signalen aus einer **Messprobe 0** mittels **HF-Spulen 13,** einen NMR-Frequenzlock umfassend eine Frequenzdetektion im NMR-Probenkopf 3 und eine H0-Spule zur Veränderung der Amplitude des statischen Magnetfeldes, und ein **Shimsystem 4** im zentralen Luftspalt 2 zur weiteren Homogenisierung des Magnetfeldes im Messvolumen.

Aus Platzgründen und wegen der besseren Übersichtlichkeit ist in sämtlichen Figuren der vorliegenden Patentzeichnung die H0-Spule nicht eigens dargestellt und hat daher auch keine eigene Bezugsziffer erhalten. Die H0-Spule fällt in den schematischen Vertikalschnittansichten räumlich (für den Betrachter) jeweils mit dem schematisch dargestellten Shimsystem 4 zusammen.

Die Permanentmagnetanordnung ist bei derartigen Anordnungen nach dem Stand der Technik direkt oder indirekt temperierbar, die Abwärme des Shimsystems und der H0-Spule wird allerdings stets direkt oder indirekt in den Magneten übertragen, da keine thermische Trennung vorhanden ist.

Die vorliegende Erfindung verbessert diese an sich bekannten Anordnungen und erweitert sie um folgende erfindungswesentlichen Elemente:
Das erfindungsgemäße Temperiersystem zeichnet sich dadurch aus, dass eine **erste Isolierkammer 5** die Permanentmagnetanordnung 1 thermisch abschirmend umschließt, dass die erste Isolierkammer 5 ein oder mehrere **Mittel 6 zur Regelung einer Temperatur T1** der ersten Isolierkammer 5 umfasst, wobei das Shimsystem 4, die H0-Spule sowie der NMR-Probenkopf 3 außerhalb der ersten Isolierkammer 5 im zentralen Luftspalt 2 angeordnet sind, und dass mindestens ein **Wärmeleitkörper 7** zwischen dem Shimsystem 4 und der H0-Spule einerseits und der Permanentmagnetanordnung 1 andererseits angeordnet ist.

Eine erste, besonders einfache Ausführungsform der Erfindung ist schematisch in **Fig. 1** dargestellt.

Da die Wärmeleitung des Magnet- und des Polschuhmaterials üblicherweise relativ schlecht ist, kann sich bei punktueller Temperierung ein Temperaturgradient im Magnetmaterial einstellen, was sich bei NMR-Messungen negativ auswirkt. Aus demselben Grund will man Konvektion vermeiden. Daher wird erfindungsgemäß auf Heizer und Peltier-Elemente, wie sie im Stand der Technik beschrieben sind, auf dem Magneten verzichtet. Stattdessen wird eine homogene Wärmestrahlung und Wärmeleitung durch das den Magneten umgebende Medium (in der Regel Fluid / Gas / Isolationskörper) angestrebt. Daher wird bei einer bevorzugten Ausführungsform auf die Regelung der Temperatur des Magneten verzichtet, und vielmehr die Umgebung vollständig und homogen temperiert. Insbesondere wird auch die Wandung im Luftspalt temperiert.

Zur initialen Anpassung der Temperatur können weitere Temperierungsmittel direkt auf dem Magneten und/oder den Polschuhen platziert werden, die jedoch nach einer Startphase nach dem Einschalten des MR-Spektrometers wieder deaktiviert werden. Solche zusätzlichen Temperierelemente sind von Vorteil, um die Zeit zur initialen Temperierung des Magneten deutlich zu verkürzen.

In **Fig. 2** ist eine bevorzugte Ausführungsform des erfindungsgemäßen Systems abgebildet, bei der die erste Isolierkammer 1 zusätzlich von einer **passiven thermischen Isolierung 9** nach außen hin umgeben ist. Zum Probenkopfbereich hin, also innerhalb der Innenkontur des Magneten, befinden sich mindestens ein Shimsystem 4 und ein Wärmeleitsystem mit mindestens einem Wärmeleitkörper 7. Der Wärmeleitkörper 7 ist thermisch verbunden mit einem **Mittel 8 zur Regelung der Temperatur T2** des Wärmeleitkörpers 7, das ein Heizer oder ein thermoelektrisches Element mit einem Wärmetauscher zur Umgebung hin sein kann. T2 wird wie T1 auf eine Temperatur zwischen 15°C bis 35°C eingestellt. Eine passive Isolation kann auch auf der zum Magnetsystem hin gewandten Seite und auf einer oder beiden Seiten des Wärmeleitkörpers angebracht werden und dient dazu, die Trägheit der Magnettemperatur zu erhöhen und den Wärmefluss in die Umgebung zu begrenzen.

Der Wärmeleitkörper 7 kann einen **Homogenisierungskörper 10** aus einem gut leitfähigen Material (z.B. Cu, Al, Al₂O₃, ...) umfassen und/oder mit einer Wärmeleitungseinrichtung **17** in Form eines Wärmerohrs ausgeführt sein, in welchem ein Fluid vorhanden ist, das abhängig von der Temperatur innerhalb des Wärmerohres verdampft bzw. kondensiert und somit Wärme abtransportieren kann. Der Wärmeleitkörper 7 ist zwischen dem Shimsystem 4 und dem Magneten angeordnet, sodass sie eine thermische Abschirmung zwischen der Permanentmagnetanordnung 1 und dem Shimsystem bildet und somit den Teil der ersten Isolierkammer innerhalb der Innenkontur des Permanentmagneten ausbildet.

In einer bevorzugten Ausführung ist der zentrale Luftspalt 2 mit dem NMR-Probenkopf 3 nach außen geschlossen. Dabei handelt es sich nicht um einen hermetischen Abschluss, sondern die Öffnung nach außen ist so ausgeführt, dass minimaler Luftaustausch zwischen der Umgebung und dem Luftspalt sichergestellt ist. So ist vorzugsweise bei eingeführtem NMR-Probenröhrchen der Spalt zum Gehäuse auf 1/10 mm begrenzt.

Im Luftspalt 2 stellt sich in der Folge eine Temperatur nahe T2 ein, die nahe, vorzugsweise identisch mit der Temperatur T1 ist, insbesondere wenn die Dissipation durch elektrische Ströme im Shimsystem und der H0-Spule durch den Wärmeleitkörper abgeführt werden. Dies ist vorteilhaft, da die Messprobentemperatur somit im Betrieb nah an der Raumtemperatur liegt und die Zeit zum Erreichen einer konstanten Messprobentemperatur nach dem Einführen einer Messprobe möglichst kurz wird.

Das Shimsystem 4 besteht aus einer Vielzahl von (in der Zeichnung nicht näher dargestellten) Shimspulen und ist vorzugsweise thermisch an das Wärmeleitsystem gekoppelt. Des Weiteren lässt sich diese Ausführungsform mit geschlossenem Messkopf in vorteilhafterweise mit einem Locksample betreiben, welches dann auch eine zweite Sende-/Empfangsspule umfasst, die das Locksample umgibt und/oder im Locksample ein HF-Signal erzeugen kann und aus dem Locksample ein HF-Signal empfangen kann, sowie mindestens eine weitere (ebenfalls nicht dargestellte) H0-Spule, die thermisch an das Wärmeleitsystem angekoppelt ist und die mit variierenden Strömen auf Frequenzveränderungen im Locksample geregelt werden. Die Bestromung der H0 Spulen würde zu einem Wärmeeintrag in den Magnetbereich führen, weshalb sich hier die thermische Abschirmung des Shimsystems 4 als besonders vorteilhaft erweist. Eine solche Erwärmung durch das Justieren von Strömen in den Shimspulen führt beispielsweise zu schlechter Konvergenz eines Shim-Algorithmus. Das Regeln der Ströme in der/den H0 Spulen kann zum «Vershimmen» des Magneten durch thermisch erzeugte Gradienten im Magnetmaterial führen. Bei alternativen Ausführungsformen sind Shimsystem und/oder H0 Spule nicht mit dem Wärmeleitkörper gekoppelt. Die durch elektrische Dissipation entstehende Wärme kann z.B. ungeregelt durch andere Wärmeleitkörper aus dem Luftspalt geführt werden und beispielsweise mit Hilfe eines Wärmetauschers an die Raumtemperatur abgegeben werden.

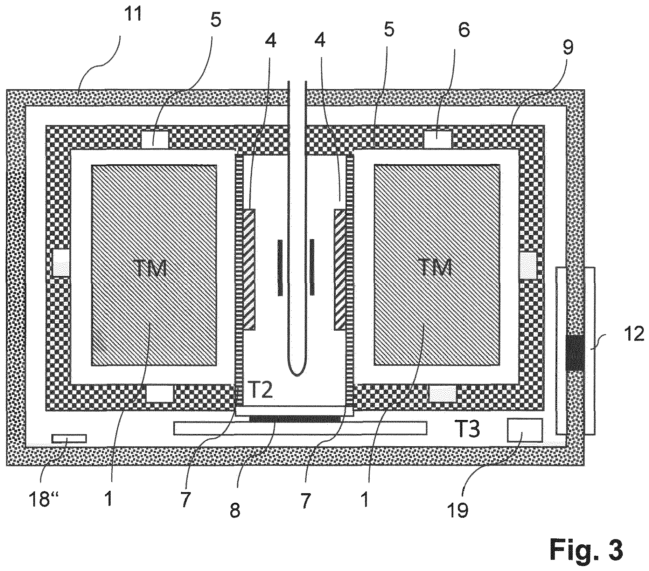

In **Fig. 3** ist eine erweiterte Ausgestaltung der Ausführungsform aus Fig. 2 abgebildet. Hier ist noch zusätzlich eine **zweite Isolierkammer 11** vorhanden, welche die erste Isolierkammer 5 umgibt. Des Weiteren ist in diesem Beispiel als Mittel 8 zur Regelung der Temperatur T2 ein thermoelektrisches Element mit einem Wärmetauscher gegenüber der Luft innerhalb der zweiten Isolierkammer 11 dargestellt. Die zweite Isolierkammer 11 wird mit Hilfe einer **Temperaturregeleinrichtung 12** auf eine Temperatur T3 geregelt, vorzugsweise auch hier mittels thermoelektrischem Element und Wärmetauscher gegen die Raumtemperatur.

Die zweite Isolierkammer 11 stellt sicher, dass die Umgebung des Magneten als Wärmesenke verwendet werden kann, unabhängig davon, wie warm es im Raum tatsächlich ist. Dadurch kann die Isotherme um den Magneten immer durch Heizen erreicht werden und man muss diese nicht auch kühlen. Dies ist für die Regelung der Temperatur T1 sicherlich immer ausreichend, da in der ersten Isolierbox außer durch Shimsystem, H0-Spule und eventuell vorhandene variable Messprobentemperatur keine Wärme eingetragen wird und diese Wärmequellen möglichst vollumfänglich an den Wärmeleitkörper angekoppelt werden und somit nur die Regelung der Temperatur T2 betreffen.

Ein Peltier (Thermoelektrisches Element) mit Wärmetauschern auf beiden Seiten der Wandung dient der Temperierung auf T3 der zweiten Isolierkammer 11. Diese erfüllt auch noch einen weiteren wichtigen Zweck: Sie ist für eine erste Reduktion der Schwankungen der Raumtemperatur verantwortlich, die eine präzise Temperierung der isothermen Wand und des Shimsystems 4 / der H0-Spulen auf die Temperaturen T1 und T2 ermöglicht, ohne hohe Anforderungen an die Umgebungstemperatur des Spektrometers zu stellen. Um die Temperatur T3 mit möglichst wenig Leistung erreichen zu können, ist es sinnvoll, eine ausreichend dimensionierte passive Isolation als Wandung der zweiten Isolierkammer vorzusehen.

Weiterhin kann bei diesen Ausführungsformen ein Peltier mit Wärmetauscher gegen die zweite Isolierkammer 11 zur Erzeugung der Temperatur T2 vorgesehen sein. Dies ist beispielsweise vorteilhaft, wenn etwa die Temperaturdifferenz und Größe des Wärmetauschers nicht ausreichen, um genug thermischen Hub für die Kühlung des Shimsystems 4 und/oder der H0 Spule und/oder des Wärmeeintrags durch variable Messprobentemperatur zu haben.

Vorzugsweise ist die erste Isolierkammer 5 aus einem thermisch gut leitenden Material hergestellt. Dies hat den Vorteil, dass die Wärmestrahlung von außen auf den Magneten möglichst homogen ist, sodass sich keine Temperaturgradienten auf dem Magneten einstellen.

Die zweite Isolierkammer 11 enthält vorzugsweise **Mittel zur Umwälzung der Luft 19** (z.B. Ventilator oder Turbine) innerhalb der zweiten Isolierkammer 11. Dies ermöglicht weitestgehend homogene Temperaturverteilungen und kann einen Luftstrom durch den/die Wärmetauscher sicherstellen.

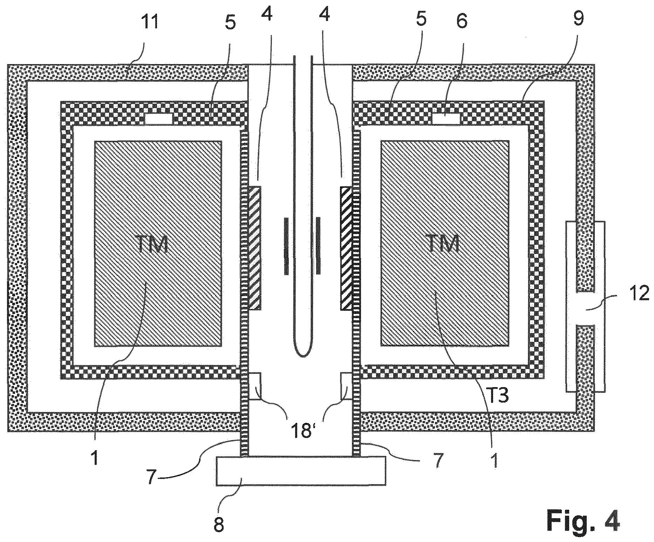

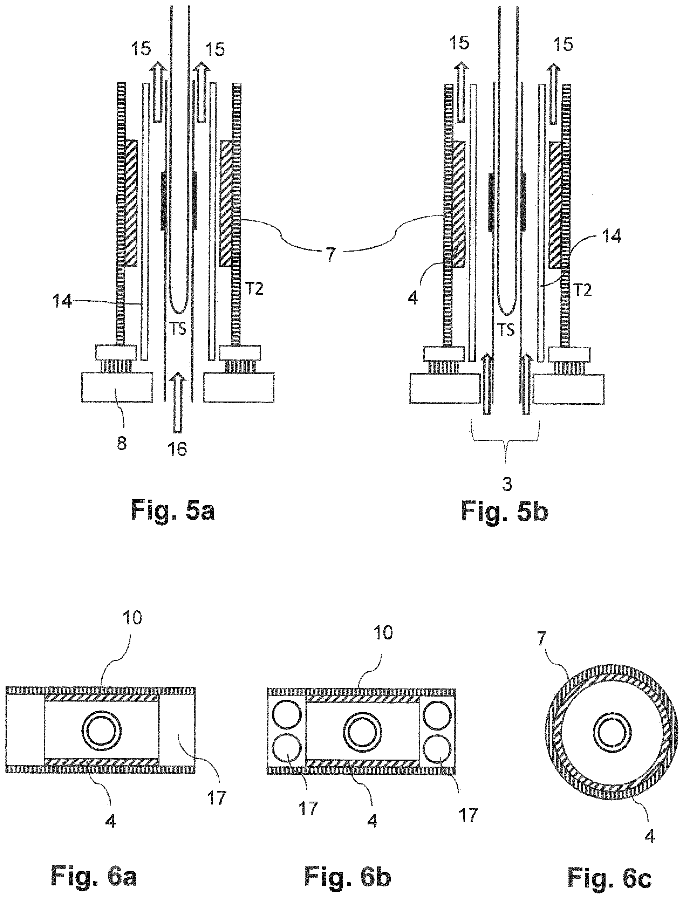

In einer alternativen Ausgestaltung -wie in **Fig. 4** gezeigt- kann das Mittel 8 zur Regelung der Temperatur T2 auch gegen die Außentemperatur regeln. Weiterhin ist in Fig. 4 eine offene Probenkammer dargestellt, sodass in dieser Ausführung auch eine Probentemperierung vorgenommen werden kann. Ein entsprechender Probenkopf mit den notwendigen Mitteln zur Temperierung von Messproben ist in Fig. 4 aus Übersichtlichkeitsgründen nicht eingezeichnet, sondern separat in der Fig. 5.

Wenn das Mittel zur Regelung der Temperatur T2 gegen die Außentemperatur und der NMR-Probenkopf 3 bis oben als separate Kammer ausgeführt sind, ist der Vorzug, dass bei hoher thermischer Last letztere nicht in die zweite Isolierkammer 11 gelangt und somit das Mittel der Temperaturregeleinrichtung 12 zur Regelung der Temperatur T3 (Peltier) der zweiten Isolierkammer 11 kleiner ausgelegt werden kann. Das gilt insbesondere, wenn man zusätzlich zur Dissipation des Shimsystems 4 / H0-Spule auch noch sehr viel Wärmelast mit einer Sampletemperierung einbringt. Die thermische Regelung des Shimsystems 4 kann erneut zweistufig ausgeführt werden, wobei noch kleine zusätzliche Heizer eingesetzt werden. Bei Dissipation der Wärme gegen die Raumtemperatur kann die Stabilität der Regelung von T2 erhöht werden, indem ein kaskadiertes System von thermoelektrischen Elementen eingesetzt wird.

Die **Figuren 5a und 5b** zeigen im Ausschnitt einen schematischen Längsschnitt durch die Probenkammer mit Shimsystem 4 und Wärmeleitkörper 7 in zwei Ausführungen mit Probentemperierung durch einen **VT-Gasstrom 16.**

Für eine optionale Regelung der Temperatur der Messprobe TS (mit TS im Bereich von -40 bis +150 °C) ist ein weiteres **thermisches Isolationssystem 14** erforderlich, das den Raum der Messprobentemperierung vom Shimsystem 4 abtrennt. Dieses besteht aus thermisch schlecht-leitendem Material (z.B. ein Vakuum, ein Aerogel, Schaumstoff, Glas, Kunststoff, ...) und beinhaltet optional einen zweiten Gasfluss in Form eines **temperierten Spülgasstromes 15** ("Flush-Gas") mit einer Temperatur TF, die vorzugsweise zwischen 15°C und 35°C liegt.

In beiden dargestellten Ausführungsformen ist zusätzlich ein Zentralrohr für die Probentemperierung vorhanden, welches das in der Regel längliche Probenröhrchen zylinderförmig umgibt. Ein solches Zentralrohr hat den Vorteil, dass es, neben der Kanalisation des VT-Gasstromes, auch im Falle eines Bruchs einer Messprobe oder Lecks in Durchflusszellen/Messproben dazu verwendet werden kann, austretende Flüssigkeit und Glasbruch zu sammeln, damit sie leichter entfernt werden können.

Das thermische Isolationssystem 14 ist zwischen den HF-Spulen 13 und dem Shimsystem 4 angeordnet.

In Fig. 5a ist eine Ausführungsform dargestellt, bei der Zentralrohr aus thermisch schlecht leitendem Material hergestellt wird und eine Isolation zwischen Flush-Gas und VT-Gas herstellt. Die Bereiche für Flush-Gas/Fluidstrom liegen hier zwischen dem Zentralrohr und der thermischen Isolierung, da somit der Temperaturgradient durch die thermische Isolierung minimiert werden kann. Zwecks Verbesserung von Temperaturgradienten innerhalb der Messproben kann es jedoch sinnvoller sein, den Flush-Gasstrom außerhalb der thermischen Isolation, z.B. zwischen dieser und dem Shimsystem hindurchzuleiten, wie in Fig. 5b dargestellt. Es ist auch denkbar, eine Kombination beider Konfigurationen zu implementieren und einen dritten Gasstrom mit einer Temperatur nahe bei TS, oder zwischen TS und TF einzusetzen.

In Fig. 5a ist eine Ausführungsform dargestellt, bei der die Messproben-temperatur direkt durch Temperiergas eingestellt werden kann. In Fig. 5b ist die Temperierung indirekt verwirklicht. Dies kann insbesondere nützlich sein um eine hermetisch abgeschlossene Probenkammer zu erzeugen, wie sie beispielsweise bei toxischen Messproben zur Vermeidung von Kontamination im Falle des Bruchs einer Messprobe verwendet wird.

Idealerweise ist die Temperatur TF des Flush-Gasstromes ungefähr gleich der Temperatur T2, damit ein möglichst geringer Wärmeeintrag in den Wärmeleitkörper ermöglicht werden kann.

Schließlich zeigen die Figuren 6a-c verschiedene Querschnitte durch Ausführungsformen des NMR-Probenkopfes 3 mit Shimsystem 4, bei denen jeweils der Wärmeleitkörper 7 einen **Homogenisierungskörper** 10 und eine **Wärmeleitungseinrichtung 17** umfasst:
**Fig. 6a** zeigt einen Wärmeleitkörper7 umfassend zwei_Homogenisierungskörper 10 und zwei Wärmeleitungseinrichtungen 17 zum Transfer der Wärme nach außen. Aufgabe der Homogenisierungskörper 10 in Plattenform ist es, die entstehende Wärme in der Ebene zu den Wärmeleitungseinrichtungen 17 zu leiten. Da die Strecke relativ kurz ist kann die Materialstärke dieser Körper reduziert werden.
In **Fig.6b** umfassen die Wärmeleitungseinrichtungen 17 je zwei_Heatpipes, wodurch die Wärmeleitung in der Richtung senkrecht zur geschnittenen Ebene signifikant erhöht werden kann.
**Fig. 6c** stellt schematisch eine Geometrie für beispielsweise Halbachmagnete mit konzentrischem Aufbau dar. Der Wärmeleitkörper besteht hier nicht separat aus Homogenisierungskörper 10 und Wärmeleitungseinrichtung 17, es können aber auch noch Heatpipes aufgelötet oder Hohlzylinder-förmige Heatpipes verwendet werden und den Wärmetransport in der Richtung senkrecht zur Zeichnungsebene zu verbessern.

Der Wärmeleitkörper 7 ist vorzugsweise thermisch verbunden mit einem Homogenisierungskörper 10. Dieser besteht insbesondere aus einem Material mit hoher Wärmeleitung, um eine möglichst homogene Temperatur T2 auf der gesamten Außenkontur des Homogenisierungskörpers 10 (zum Magneten hin ausgerichtet) einzustellen.

Die Wärmeleitungseinrichtung 17 ist mit einem Wärmetauscher verbunden und dient zum Transport von Wärme in den Homogenisierungskörper 10 oder aus diesem heraus. Vorzugsweise ist die Wärmeleitungseinrichtung 17 aus einem Material mit hoher Wärmeleitfähigkeit oder als Wärmerohr (Heatpipe) aufgebaut.

Vorzugsweise ist das Shimsystem und/oder die H0-Spule thermisch direkt an den Wärmeleitkörper 7, insbesondere an die Homogenisierungskörper 10 gekoppelt. Somit kann sichergestellt werden, dass die durch elektrische Ströme herausgeführt werden kann.

Ein wesentlicher Unterschied zu bekannten Geräten des Standes der Technik liegt in der Regelung der Temperatur T2, die von der Innenkontur des Magneten «gesehen wird». Weiterhin ist es neu, eine thermische Isolation zwischen der Probentemperierkammer und dem Shimsystem einzuführen. Aus den oben zitierten Dokumenten geht hervor, dass beim Stand der Technik die Isolation stets zwischen der Messprobe und der inneren Wand einer Probentemperierkammer, insbesondere jedoch innerhalb der Sende/Empfangsspule, platziert wird.

Die Merkmale aller oben beschriebenen Ausführungsformen der Erfindung können -jedenfalls größtenteils- auch miteinander kombiniert werden, sofern das Resultat unter die Ansprüche fällt.

### Referenzliste:

Für die Beurteilung der Patentfähigkeit in Betracht gezogene Druckschriften
- [0]: DE 10 2010 002316 A1
- [1]: US 2011/0137589 A1 ≈ EP 2 507 643 A1
- [2]: US 8,461,841 B2
- [3]: US 6,489,873 B1
- [4]: US 6,566,880 B1 und WO 2000/016117 A1
- [5]: GB 2512328 A
- [6]: US 8,030,927 B2
- [7]: US 7,297,907 B2
- [8]: US 2013/0207657 A1
- [9]: US 9,285,441 B1
- [10]: US 2011/0037467 A1
- [11]: US 2018/0038924 A1
- [12]: US 2016/0077176 A1
- [13]: JP H05 212012 A
- [14]: JP H05 285118 A

### Bezugszeichenliste:

- 0: Messprobe
- 1: Permanentmagnetanordnung
- 2: zentraler Luftspalt
- 3: NMR-Probenkopf
- 4: Shimsystem
- 5: erste Isolierkammer
- 6: Mittel zur Regelung der Temperatur T1
- 7: Wärmeleitkörper
- 8: Mittel zur Regelung der Temperatur T2
- 9: passive thermische Isolation
- 10: Homogenisierungskörper
- 11: zweite Isolierkammer
- 12: Temperaturregeleinrichtung
- 13: HF-Spule
- 14: thermisches Isolationssystem
- 15: temperierter Spülgasstrom
- 16: temperierter VT-Gasstrom
- 17: Wärmeleitungseinrichtung
- 18: T-Sensor zur Messung von T1
- 18': T-Sensor zur Messung von T2
- 18": T-Sensor zur Messung von T3
- 19: Mittel zur Umwälzung der Luft

## Patentansprüche

1. Temperiersystem für ein NMR-Magnetsystem umfassend
eine Permanentmagnetanordnung (1) mit einem zentralen Luftspalt (2) zur Erzeugung eines homogenen statischen Magnetfeldes in einem Messvolumen innerhalb des zentralen Luftspalts (2),
einen NMR-Probenkopf (3) zum Senden von HF-Pulsen und Empfangen von HF-Signalen aus einer Messprobe (0),
eine H0-Spule zur Veränderung der Amplitude des statischen Magnetfeldes,
und ein Shimsystem (4) im zentralen Luftspalt (2) zur weiteren Homogenisierung des Magnetfeldes im Messvolumen,
wobei eine erste Isolierkammer (5) die Permanentmagnetanordnung (1) thermisch abschirmend umschließt,
und wobei die erste Isolierkammer (5) ein oder mehrere Mittel (6) zur Regelung einer Temperatur T1 der ersten Isolierkammer (5) umfasst, **dadurch gekennzeichnet,**
**dass** das Shimsystem (4), die H0-Spule sowie der NMR-Probenkopf (3) außerhalb der ersten Isolierkammer (5) im zentralen Luftspalt (2) angeordnet sind,
und **dass** mindestens ein Wärmeleitkörper (7) zwischen dem Shimsystem (4) und der H0-Spule einerseits und der Permanentmagnetanordnung (1) andererseits angeordnet ist.

2. Temperiersystem nach Anspruch 1, **dadurch gekennzeichnet, dass** ein oder mehrere Mittel (8) zur Regelung einer Temperatur T2 des Wärmeleitkörpers (7) außerhalb der ersten Isolierkammer (5) angeordnet sind.

3. Temperiersystem nach Anspruch 2, **dadurch gekennzeichnet, dass** die die Permanentmagnetanordnung (1) umhüllende erste Isolierkammer (5) eine Wandung aus mindestens zwei thermisch getrennten Flächen aufweist, die jeweils mindestens einen Sensor zur Bestimmung einer Oberflächentemperatur T1i der Wandung umfassen und eine voneinander unabhängige thermische Regelung aufweisen, wobei eine der mindestens zwei thermisch getrennten Flächen den das Messvolumen umgebenden zentralen Luftspalt (2) umgibt und das Shimsystem (4), die H0-Spule und den NMR-Probenkopf (3) aktiv thermisch von der Permanentmagnetanordnung (1) trennt.

4. Temperiersystem nach einem der vorhergehenden Ansprüche, **dadurch gekennzeichnet, dass** mindestens eines der Mittel (6 bzw. 8) zur Regelung der Temperatur T1 der ersten Isolierkammer (5) oder der Temperatur T2 des Wärmeleitkörpers (7) ein thermoelektrisches Element ist und einen Wärmetauscher aufweist.

5. Temperiersystem nach einem der vorhergehenden Ansprüche, **dadurch gekennzeichnet, dass** die Wandung der ersten Isolierkammer (5) als Abschirmanordnung zur magnetischen Abschirmung des Magnetfeldes gegenüber einem Außenraum gestaltet ist und vorzugsweise eine passive thermische Isolation (9) auf der Außenseite der ersten Isolierkammer (5) umfasst.

6. Temperiersystem nach einem der vorhergehenden Ansprüche, **dadurch gekennzeichnet, dass** der Wärmeleitkörper (7) aus einem Homogenisierungskörper (10) und einer Wärmeleitungseinrichtung besteht, wobei der Homogenisierungskörper (10) dazu dient, die Wärme möglichst homogen über seine gesamte Fläche zu verteilen, sodass die Temperaturgradienten minimal sind.

7. Temperiersystem nach Anspruch 6, **dadurch gekennzeichnet, dass** die Wärmeleitungseinrichtung mindestens eine Heatpipe umfasst.

8. Temperiersystem nach Anspruch 6 oder 7, **dadurch gekennzeichnet, dass** der Homogenisierungskörper (10) thermisch mit dem Shimsystem (4) und der H0-Spule verbunden ist.

9. Temperiersystem nach einem der Ansprüche 6 bis 8, **dadurch gekennzeichnet, dass** mindestens ein Teil des Homogenisierungskörpers (10) zwischen dem Shimsystem (4) und der Permanentmagnetanordnung (1) angeordnet ist.

10. Temperiersystem nach Anspruch 2 und gegebenenfalls einem der Ansprüche 3 bis 9, **dadurch gekennzeichnet, dass** das Mittel (8) zur Regelung der Temperatur T2 im zentralen Luftspalt (2) einen Heizer und/oder ein Thermometer zur Messung der Temperatur T2 umfasst und thermisch mit dem Shimsystem (4) verbunden ist.

11. Temperiersystem nach einem der vorhergehenden Ansprüche, **dadurch gekennzeichnet, dass** die erste Isolierkammer (5) von einer zweiten Isolierkammer (11) umgeben ist, welche auf einer Temperatur T3 liegt und mit welcher die Temperatur T3 im Inneren der zweiten Isolierkammer (11) gegenüber der Umgebungstemperatur TR außerhalb der zweiten Isolierkammer (11) isoliert wird.

12. Temperiersystem nach Anspruch 11, **dadurch gekennzeichnet, dass** eine Temperaturregeleinrichtung (12) an der Außenwand der zweiten Isolierkammer (11) vorhanden ist, welche die Temperatur T3 im inneren der zweiten Isolierkammer (11) gegen die Umgebungstemperatur TR außerhalb der zweiten Isolierkammer (11) regelt.

13. Temperiersystem nach einem der vorhergehenden Ansprüche, **dadurch gekennzeichnet, dass** der Probenkopf (3) Mittel zur Einstellung der Temperatur TS einer Messprobe (0) im Messvolumen aufweist, die unabhängig von der Temperatur der die Permanentmagnetanordnung (1) umhüllenden Wandung der ersten Isolierkammer (5) einstellbar ist.

14. Temperiersystem nach Anspruch 13, **dadurch gekennzeichnet, dass** ein thermisches Isolationssystem (14) zwischen dem Shimsystem (4) und mindestens einer HF-Spule (13) des NMR-Probenkopfes (3) angeordnet ist, wobei vorzugsweise ein auf eine Temperatur TF temperierter Spülgasstrom (15) durch den NMR-Probenkopf (3), das Shimsystem (4) oder die H0-Spule fließt.

## Claims

1. A temperature-control system for an NMR magnet system, comprising
a permanent magnet arrangement (1) with a central air gap (2) for generating a homogeneous static magnetic field in a measuring volume inside the central air gap (2),
an NMR probehead (3) for transmitting RF pulses and receiving RF signals from a measuring sample (0),
an H0 coil for changing the amplitude of the static magnetic field,
and a shim system (4) in the central air gap (2) for further homogenization of the magnetic field in the measuring volume,
wherein a first insulation chamber (5) surrounds the permanent magnet arrangement (1) so as to thermally shield it,
and wherein the first insulation chamber (5) comprises one or more means (6) for controlling a temperature T1 of the first insulation chamber (5),
**characterized in that**
the shim system (4), the H0 coil and the NMR probehead (3) are arranged outside the first insulation chamber (5) in the central air gap (2),
and **in that** at least one heat-conducting body (7) is arranged between the shim system (4) and the H0 coil on one side and the permanent magnet arrangement (1) on the other side.

2. The temperature-control system according to claim 1, **characterized in that** one or more means (8) for controlling a temperature T2 of the heat-conducting body (7) is/are arranged outside the first insulation chamber (5).

3. The temperature-control system according to claim 2, **characterized in that** the first insulation chamber (5) that envelopes the permanent magnet arrangement (1) comprises a wall consisting of at least two thermally separated faces, each of which comprises at least one sensor for determining a surface temperature T1i of the wall and which are thermally controlled independently of one another, one of the at least two thermally separated faces encompassing the central air gap (2) that encompasses the measuring volume and actively thermally separates the shim system (4), the H0 coil and the NMR probehead (3) from the permanent magnet arrangement (1).

4. The temperature-control system according to any one of the preceding claims, **characterized in that** at least one of the means (6 or 8, respectively) for controlling the temperature T1 of the first insulation chamber (5) or the temperature T2 of the heat-conducting body (7) is a thermoelectric element and comprises a heat exchanger.

5. The temperature-control system according to any one of the preceding claims, **characterized in that** the wall of the first insulation chamber (5) is designed as a shielding arrangement for magnetically shielding the magnetic field with respect to an external space and preferably comprises a piece of passive thermal insulation (9) on the outside of the first insulation chamber (5).

6. The temperature-control system according to any one of the preceding claims, **characterized in that** the heat-conducting body (7) consists of a homogenization body (10) and a heat-conducting device, wherein the homogenization body (10) serves to distribute the heat as homogeneously as possible over its entire face such that the temperature gradients are minimum.

7. The temperature-control system according to claim 6, **characterized in that** the heat-conducting device comprises at least one heat pipe.

8. The temperature-control system according to either claim 6 or claim 7, **characterized in that** the homogenization body (10) is thermally connected to the shim system (4) and the H0 coil.

9. The temperature-control system according to any one of claims 6 to 8, **characterized in that** at least part of the homogenization body (10) is arranged between the shim system (4) and the permanent magnet arrangement (1).

10. The temperature-control system according to claim 2 and optionally any one of claims 3 to 9, **characterized in that** the means (8) for controlling the temperature T2 in the central air gap (2) comprises a heater and/or a thermometer for measuring the temperature T2, and is thermally connected to the shim system (4).

11. The temperature-control system according to any one of the preceding claims, **characterized in that** the first insulation chamber (5) is encompassed by a second insulation chamber (11), which is at a temperature T3 and by means of which the temperature T3 inside the second insulation chamber (11) is insulated with respect to the ambient temperature TR outside the second insulation chamber (11).

12. The temperature-control system according to claim 11, **characterized in that** a temperature control device (12) is provided on the outer wall of the second insulation chamber (11), which controls the temperature T3 inside the second insulation chamber (11) with respect to the ambient temperature TR outside the second insulation chamber (11).

13. The temperature-control system according to any one of the preceding claims, **characterized in that** the probehead (3) comprises means for setting the temperature TS of a measuring sample (0) in the measuring volume, which can be set independently of the temperature of the wall of the first insulating chamber (5) enveloping the permanent magnet arrangement (1).

14. The temperature-control system according to claim 13, **characterized in that** a thermal insulation system (14) is arranged between the shim system (4) and at least one RF coil (13) of the NMR probehead (3), wherein preferably a flush gas flow (15) tempered to a temperature TF flows through the NMR probehead (3), the shim system (4) or the H0 coil.

## Revendications

1. Système de thermorégulation pour un système d'aimant RMN, comprenant
un arrangement d'aimants permanents (1) avec un entrefer central (2) destiné à générer un champ magnétique statique homogène dans un volume de mesure à l'intérieur de l'entrefer central (2),
une tête d'échantillonnage RMN (3) destinée à émettre des impulsions HF et à recevoir des signaux HF en provenance d'une sonde de mesure (0),
une bobine H0 destinée à modifier l'amplitude du champ magnétique statique,
et un système de cale (4) dans l'entrefer central (2) destiné à une homogénéisation supplémentaire du champ magnétique dans le volume de mesure,
une première chambre isolante (5) entourant l'arrangement d'aimants permanents (1) en réalisant un bouclier thermique,
et la première chambre isolante (5) comprenant un ou plusieurs moyens (6) destinés à réguler une température T1 de la première chambre isolante (5),
**caractérisé en ce**
**que** le système de cale (4), la bobine H0 ainsi que la tête d'échantillonnage RMN (3) sont disposés en-dehors de la première chambre isolante (5) dans l'entrefer central (2),
et en ce qu'au moins un corps conducteur de chaleur (7) est disposé entre le système de cale (4) et la bobine H0 d'une part et l'arrangement d'aimants permanents (1) d'autre part.

2. Système de thermorégulation selon la revendication 1, **caractérisé en ce qu'**un ou plusieurs moyens (8) destinés à réguler une température T2 du corps conducteur de chaleur (7) sont disposés à l'extérieur de la première chambre isolante (5).

3. Système de thermorégulation selon la revendication 2, **caractérisé en ce que** la première chambre isolante (5) qui enveloppe l'arrangement d'aimants permanents (1) possède une paroi composée d'au moins deux surfaces thermiquement séparées, qui comportent respectivement au moins un capteur destiné à déterminer une température de surface T1i de la paroi et possèdent une régulation thermique indépendante l'une de l'autre, l'une des au moins deux surfaces thermiquement séparées entourant l'entrefer central (2) qui entoure le volume de mesure et séparant thermiquement activement le système de cale (4), la bobine H0 et la tête d'échantillonnage RMN (3) de l'arrangement d'aimants permanents (1).

4. Système de thermorégulation selon l'une des revendications précédentes, **caractérisé en ce que** l'au moins un moyen (6 ou 8) destiné à réguler une température T1 de la première chambre isolante (5) ou la température T2 du corps conducteur de chaleur (7) est un élément thermoélectrique et possède un échangeur de chaleur.

5. Système de thermorégulation selon l'une des revendications précédentes, **caractérisé en ce que** la paroi de la première chambre isolante (5) est configurée en tant qu'arrangement de blindage servant au blindage magnétique du champ magnétique par rapport à l'espace extérieur et comprend de préférence une isolation thermique passive (9) sur le côté extérieur de la première chambre isolante (5).

6. Système de thermorégulation selon l'une des revendications précédentes, **caractérisé en ce que** le corps conducteur de chaleur (7) se compose d'un corps d'homogénéisation (10) et d'un dispositif de conduction de chaleur, le corps d'homogénéisation (10) servant à distribuer la chaleur de la manière la plus homogène possible sur la totalité de sa surface, de sorte que le gradient de température soit minimal.

7. Système de thermorégulation selon la revendication 6, **caractérisé en ce que** le dispositif de conduction de chaleur comporte au moins un caloduc.

8. Système de thermorégulation selon la revendication 6 ou 7, **caractérisé en ce que** le corps d'homogénéisation (10) est relié thermiquement au système de cal (4) et à la bobine H0.

9. Système de thermorégulation selon l'une des revendications 6 à 8, **caractérisé en ce qu'**au moins une partie du corps d'homogénéisation (10) est disposée entre le système de cale (4) et l'arrangement d'aimants permanents (1).

10. Système de thermorégulation selon la revendication 2 et éventuellement selon l'une des revendications 3 à 9, **caractérisé en ce que** le moyen (8) destiné à réguler la température T2 dans l'entrefer central (2) comprend un élément chauffant et/ou un thermomètre servant à mesurer la température T2 et il est relié thermiquement au système de cale (4).

11. Système de thermorégulation selon l'une des revendications précédentes, **caractérisé en ce que** la première chambre isolante (5) est entourée par une deuxième chambre isolante (11) qui se trouve à une température T3 et avec laquelle la température T3 à l'intérieur de la deuxième chambre isolante (11) est isolée par rapport à la température ambiante TR à l'extérieur de la deuxième chambre isolante (11).

12. Système de thermorégulation selon la revendication 11, **caractérisé en ce qu'**un dispositif de régulation de température (12) se trouve sur la paroi extérieure de la deuxième chambre isolante (11), lequel régule la température T3 à l'intérieur de la deuxième chambre isolante (11) par rapport à la température ambiante TR à l'extérieur de la deuxième chambre isolante (11) .

13. Système de thermorégulation selon l'une des revendications précédentes, **caractérisé en ce que** la tête d'échantillonnage (3) possède des moyens servant à régler la température TS d'une sonde de mesure (0) dans le volume de mesure, laquelle peut être réglée indépendamment de la température de la paroi de la première chambre isolante (5) qui enveloppe l'arrangement d'aimants permanents (1).

14. Système de thermorégulation selon la revendication 13, **caractérisé en ce qu'**un système d'isolation thermique (14) est disposé entre le système de cale (4) et au moins une bobine HF (13) de la tête d'échantillonnage RMN (3), un flux de gaz de rinçage (15) thermorégulé à une température TF s'écoulant de préférence à travers la tête d'échantillonnage RMN (3), le système de cale (4) ou la bobine H0.
